# EUROPEAN PATENT APPLICATION

(11) **EP 4 333 074 A1**
(43) Date of publication of application: **06.03.2024**
(21) Application number: 22193840.0
(22) Date of filing: 05.09.2022
(51) Int. Cl.: H01L 29/78, H01L 29/40, H01L 29/423, H01L 21/336

(54) **A SEMICONDUCTOR DEVICE AND A METHOD OF MANUFACTURING OF A SEMICONDUCTOR DEVICE**

(71) Applicant: Nexperia B.V., 6534 AB Nijmegen (NL)
(72) Inventor: Kumar, Manoj, 22529 Hamburg (DE); Ong, Kilian, 22529 Hamburg (DE)
(74) Representative: Pjanovic, Ilija

(57) **Abstract**

The present disclosure proposes a semiconductor device comprising a silicon substrate; a channel positioned on the top surface of the substrate; a drift region positioned on the top of the channel; a trench; a first polysilicon layer positioned within the channel and the drift region on the bottom of the trench; a second polysilicon layer positioned on the top of the first polysilicon layer, and positioned within the drift region inside of the trench; a third polysilicon layer positioned on the top of the second polysilicon layer, and positioned within the drift region inside of the trench; wherein the first polysilicon layer and the second polysilicon layer and the third polysilicon layer are isolated by a gate oxide and a RESURF oxide respectively, from the channel and from the drift and from each other forming at least partially three separated structures.

## Description

### TECHNICAL FIELD

The present disclosure relates to a semiconductor device. The disclosure also relates to a method of manufacturing of a semiconductor device.

### BACKGROUND OF THE DISCLOSURE

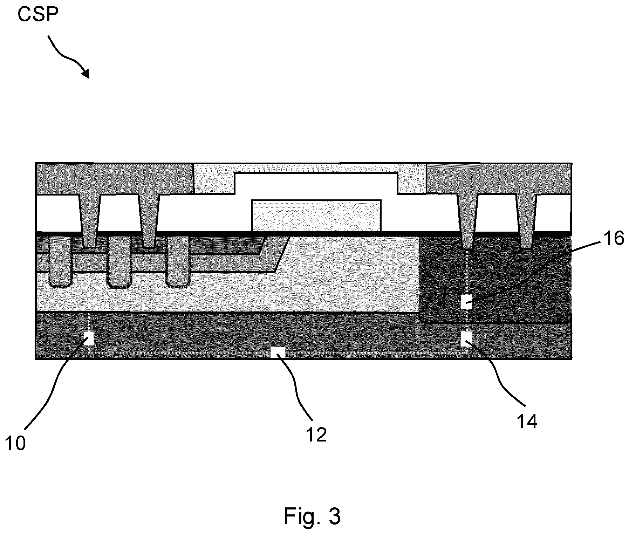

A known semiconductor device according to the state of the art is shown in Figure 3. It is known in such a chip scale packaging (CSP) product, that a drain-source on resistance (Rdson) is being contributed by a technology Rspec 10, a bidirectional resistance 12, a drain side substrate spreading resistance 14 and a drain side epitaxial (EPI) spreading resistance 16. It is known that both the bidirectional resistance 12 and the drain side EPI spreading resistance 16 can be reduced by a backside metallization and deep implants or deep metal, respectively. It is however problematic to manage the drain side substrate spreading resistance 14. This drain side substrate spreading resistance 14 is fixed for any voltage class. For a low breakdown (BV) voltage class the technology Rdson is low, but the total Rdson will be high as drain side substrate spreading resistance 14 directly adds up to the technology Rdson.

A semiconductor package disclosed in US7851856B2 comprises a semiconductor substrate, a MOSFET device having a plurality cells formed on the substrate, and a source region common to all cells disposed on a bottom of the substrate. Each cell comprises a drain region on a top of the semiconductor device, a gate to control a flow of electrical current between the source and drain regions, a source contact proximate the gate; and an electrical connection between the source contact and source region. At least one drain connection is electrically coupled to the drain region. Source, drain, and gate pads are electrically connected to the source region, drain region and gates of the devices. The drain, source and gate pads are formed on one surface of the semiconductor package. The cells are distributed across the substrate, whereby the electrical connections between the source contact of each device and the source region are distributed across the substrate.

A known semiconductor transistor disclosed in US20110241113A includes an n-well implanted in a substrate, a source region including a p-body region in the n-well, and a n+ region and a p+ region in the p-body region, a drain region including a n+ region, and a dual gate between the source region and the drain region. The dual gate includes a first gate on a side closer to the source region and a second gate on a side closer to the drain region, the first gate separated from the second gate by a pre-determined distance sufficient that a capacitance between the gate and the drain is at least 15% lower than a capacitance of a transistor of the same unit cell size and configuration excepting that the first gate and second gate abut.

A known semiconductor device is described in US9159786B2. This device is a dual gate lateral MOSFET comprises a drift region over a substrate, an isolation region formed in the drift region and a channel region formed in the drift region. The dual gate lateral MOSFET comprises a drain region formed in the drift region and a source region formed in the channel region, wherein the source region and drain region are formed on opposing sides of the isolation region. The dual gate lateral MOSFET further comprises a first gate and a second gate formed adjacent to the source region, wherein the first gate and the second gate are stacked together and separated by a dielectric layer.

Accordingly, it is a goal of the present disclosure to provide an improved semiconductor device in which the current path between drain and source can be made in a way that it skips substrate spreading resistance and therefore the back metallisation can be skipped. Using one bi-directional switch instead of two unidirectional switches in series could reduce the RDSon significantly. The device structure according to the disclosure provides one CSP current path and one channel resistance.

### SUMMARY OF THE DISCLOSURE

According to a first example of the disclosure, a semiconductor device is proposed, comprising: a silicon substrate and a channel, wherein the channel is positioned on the top of the substrate, and a drift region, wherein the drift region is positioned on the top of the channel. Silicon devices according to the disclosure further comprises a trench, a first polysilicon layer positioned within the channel and the drift region on the bottom of the trench and a second polysilicon layer positioned on the top of the first polysilicon layer, and positioned within the drift region in side of the trench, and a third polysilicon layer positioned on the top of the second polysilicon layer, and positioned within the drift region in side of the trench. The semiconductor device comprises a first polysilicon layer and the second polysilicon layer and the third polysilicon layer that are isolated by a gate oxide and a RESURF oxide respectively, from the channel and from the drift and from each other forming at least partially three separated structures.

The first polysilicon layer is thicker compared to the second polysilicon layer.

The third polysilicon layer is thicker compared to the second polysilicon layer or the first polysilicon layer.

According to the disclosure the semiconductor device further comprises a gate terminal, wherein the first polysilicon layer and the second polysilicon layer is connected to the gate terminal.

The semiconductor device further comprises a source and the third polysilicon layer is floating or is connected to the source.

The semiconductor device, according to the disclosure is a bi-directional MOSFET device and may further comprises and additional EPI layer functioning as the channel provided between the substrate and the drift region.

In the semiconductor device, according to the disclosure, the oxidation thickness between the drift region and the third polysilicon layer is thicker than the oxidation thickness between the drift region and the first polysilicon layer and the second polysilicon layer.

In the semiconductor device, according to the disclosure wherein the oxidation thickness between the drift region and the second polysilicon layer is thicker than the oxidation thickness between the drift region and the first polysilicon layer and less thick than the oxidation thickness between the drift region and the third polysilicon layer.

The disclosure also relates to a method of manufacturing of a semiconductor device. According to an example, the method comprises the steps:
- providing a silicon substrate;
- creating a N-well for a N-channel and a P-well for a P-channel, wherein the N-well and the P-well form a drift region, and wherein the drift region is positioned on the top of the substrate;
- etching a trench;
- growing a sacrificial (SAC) oxide and a gate terminal oxide (GOX) within the trench;
- deposing a first polysilicon layer in the trench;
- removing a top part of the first polysilicon layer;
- deposit or grow a RESURF oxide on the top of the first polysilicon layer;
- deposit a second polysilicon layer on the top of the RESURF oxide;
- removing a top part of the second polysilicon layer;
- deposit or grow a RESURF oxide on the top of the second polysilicon layer;
- deposit a third polysilicon layer on the top of the RESURF oxide, and
- inserting a high concentration implant so to form a source, a drain and a contact open so to pick up the source and the drain.

### BRIEF DESCRIPTION OF THE DRAWINGS

The disclosure will now be discussed with reference to the drawings, which show in:
Figure 1 illustrates a schematic cross section of semiconductor device according to an example of the disclosure;
Figure 2 illustrates a schematic cross section of semiconductor device according to an example of the disclosure;
Figure 3 shows a schematic cross section of a semiconductor device known in prior art.

### DETAILED DESCRIPTION OF THE DISCLOSURE

For a proper understanding of the disclosure, in the detailed description below corresponding elements or parts of the disclosure will be denoted with identical reference numerals in the drawings.

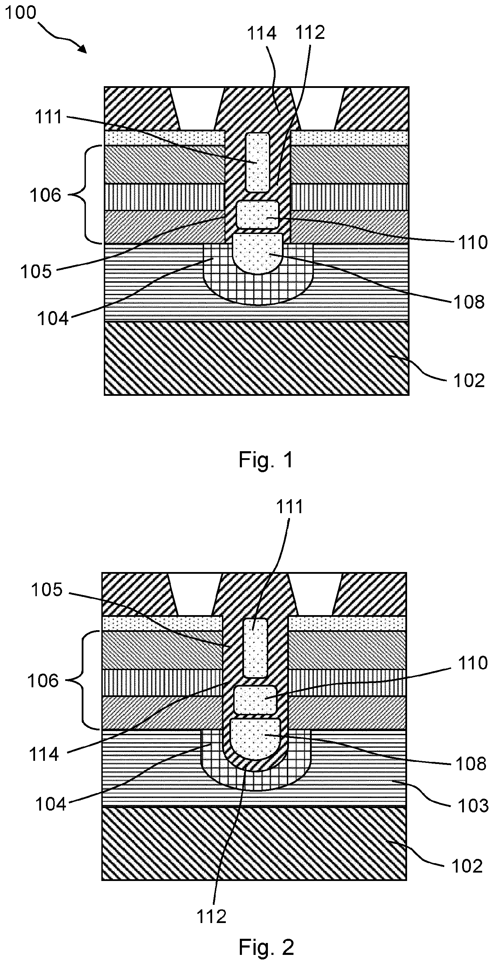

Figure 1 illustrates a semiconductor device according to an example of the disclosure. The semiconductor device is denoted with reference numeral 100 and comprises a silicon substrate 102 and a channel 104, wherein the channel 104 is positioned on the top side of the substrate 102. The semiconductor device further compromises a drift region 106, wherein the drift region 106 is positioned on the top of the channel 104 and on the substrate 102. The semiconductor device 100 has a trench 105 extending through the drift region 106 and into the channel 104 on the substrate 102. On the bottom part of the trench 105, a first polysilicon layer 108 is positioned within the channel 104 and extending in part into the drift region 106. On the top of the first polysilicon layer 108 inside of the trench 105 a second polysilicon layer 110 is positioned within the drift region 106. Furthermore, a third polysilicon layer 111 is positioned on the top of the second polysilicon layer 110 within the drift region 106 and in the trench 105.

In the device according to this example the first polysilicon layer 108 and the second polysilicon layer 110 and the third polysilicon layer 111 are isolated from each other by means of a gate oxide 112 in the trench 105 and a RESURF oxide 114 on top of the drift region 106. The first polysilicon layer 108 and the second polysilicon layer 110 and the third polysilicon layer 111 thus form at least partially three separated structures.

In another example of semiconductor device according to the disclosure the first polysilicon layer 108 is thicker compared to the thickness of the second polysilicon layer 110. The thickness variation provides a better control of the oxidation thickness between first polysilicon layer 108 and the drift region 106.

In another example of the semiconductor device the thickness of the third polysilicon layer 111 is larger compared to the thickness of the second polysilicon layer 110 or the thickness of the first polysilicon layer 108. The thickness variation provides a better control of the oxidation thickness between first polysilicon layer 108 and the drift region 106 and also between the second polysilicon layer 110 the drift region 106.

In yet another example the oxidation thickness between the drift region 106 and the third polysilicon layer 111 is thicker (larger) than the oxidation thickness between the drift region 106 and the first polysilicon layer 108 and the second polysilicon layer 108.

Another example of the disclosure pertains to a semiconductor device wherein the oxidation thickness between the drift region 106 and the second polysilicon layer 108 is thicker (larger) than the oxidation thickness between the drift region 106 and the first polysilicon layer 108 and less thick than the oxidation thickness between the drift region 106 and the third polysilicon layer 111.

The thickness grade, described in above mentioned examples allow precise control of the oxidation thickest in the trench 105, which provide a better thermal and electrical efficiency of semiconductor devices if current flow is applied. This significantly increases the breakdown voltage of the semiconductor device.

All above mentioned examples disclose a semiconductor device which further comprises a gate terminal, wherein the first polysilicon layer 108 and the second polysilicon layer 110 is connected to the gate terminal. The semiconductor device also comprise a source terminal and the third polysilicon layer 111 is floating or is connected to the source terminal. In this example the semiconductor device may be described as a bidirectional MOSFET device.

In another example, the semiconductor device according 100 further comprises an additional EPI layer 103 functioning as the channel 104 provided between the substrate 102 and the drift region 106.

The disclosure also relates to a method for producing or manufacturing a semiconductor device according to any one of the examples disclosed. The method comprises steps
a. providing a silicon substrate 102;
b. creating a N-well for a N-channel and a P-well for a P-channel, wherein the N-well and the P-well form a drift region 106, and wherein the drift region 106 is positioned on the top of the substrate 102;
c. etching a trench 105 in the drift region 106 and in part in the substrate 102;
d. growing a sacrificial, SAC, oxide and a gate terminal oxide GOX within the trench 105;
e. deposing a first polysilicon layer 108 in the trench 105;
f. removing a top part of the first polysilicon layer 108;
g. deposit or grow a RESURF oxide on the top of the first polysilicon layer 108;
h. deposit a second polysilicon layer 110 on the top of the RESURF oxide;
i. removing a top part of the second polysilicon layer 110;
j. deposit or grow a RESURF oxide on the top of the second polysilicon layer 110;
k. deposit a third polysilicon layer 111 on the top of the RESURF oxide, and
l. inserting a high concentration implant so to form a source, a drain and a contact open so to pick up the source and the drain.

The semiconductor devices manufactured according to this method has better performance compared to the semiconductor devices known in the art.

Features which are described in the context of separate examples may also be provided in combination in a single example. Conversely, various features which are, for brevity, described in the context of a single example, may also be provided separately or in any suitable sub combination.

Term "comprising" does not exclude other elements or steps, the term "a" or "an" does not exclude a plurality. Reference signs in the claims shall not be construed as limiting the scope of the claims.

### LIST OF REFERENCE NUMERALS USED

### PRIOR ART

- 10: technology Rspec
- 12: bidirectional resistance 12
- 14: drain side substrate spreading resistance
- 16: drain side epitaxial (EPI) spreading resistance

### DISCLOSURE

- 100: semiconductor device
- 102: silicon substrate
- 103: EPI layer
- 104: channel
- 105: trench
- 106: drift region
- 108: first polysilicon layer
- 110: second polysilicon layer
- 111: a third polysilicon layer
- 112: gate oxide
- 114: RESURF oxide
- SAC: sacrificial oxide
- GOX: oxide and a gate terminal oxide

## Claims

1. A semiconductor device comprising:
a. a silicon substrate (102);
b. a channel (104), wherein the channel is positioned on the top surface of the substrate (102);
c. a drift region (106), wherein the drift region (106) is positioned on the top of the channel (104);
d. a trench (105);
e. a first polysilicon layer (108) positioned within the channel (104) and the drift region (106) on the bottom of the trench (105);
f. a second polysilicon layer (110) positioned on the top of the first polysilicon layer (108), and positioned within the drift region (106) in side of the trench (105);
g. a third polysilicon layer (111) positioned on the top of the second polysilicon layer (110), and positioned within the drift region (106) in side of the trench (105);
wherein the first polysilicon layer (108) and the second polysilicon layer (110) and the third polysilicon layer (111) are isolated by a gate oxide (112) and a RESURF oxide (114) respectively, from the channel and from the drift and from each other forming at least partially three separated structures.

2. A semiconductor device according to claim 1, wherein the first polysilicon layer (108) is thicker compared to the second polysilicon layer (110).

3. A semiconductor device according to claim 1 or 2, wherein the third polysilicon layer (111) is thicker compared to the second polysilicon layer (110) or the first polysilicon layer (108).

4. A semiconductor device according to any of the previous claims, wherein the semiconductor device (100) further comprises a gate terminal, wherein the first polysilicon layer (108) and the second polysilicon layer (110) are connected to the gate terminal.

5. A semiconductor device according to any of the previous claims, wherein the semiconductor device (100) further comprises a source and wherein the third polysilicon layer (111) is floating or is connected to the source.

6. A semiconductor device according to any of the previous claims, wherein the semiconductor device is a bi-directional MOSFET device.

7. A semiconductor device according to any of the previous claims, wherein the semiconductor device (100) further comprises and additional EPI layer (103) functioning as the channel (104) provided between the substrate (102) and the drift region (106).

8. A semiconductor device according to any of the previous claims, wherein the oxidation thickness between the drift region (106) and the third polysilicon layer (111) is thicker than the oxidation thickness between the drift region (106) and the first polysilicon layer (108) and the second polysilicon layer (108);

9. A semiconductor device according to any of the previous claims, wherein the oxidation thickness between the drift region (106) and the second polysilicon layer (108) is thicker than the oxidation thickness between the drift region (106) and the first polysilicon layer (108) and less thick than oxidation thickness between the drift region (106) and the third polysilicon layer (111);

10. A method of producing a semiconductor device, the method comprising the steps:
a. providing a silicon substrate (102);
b. creating a N-well for a N-channel and a P-well for a P-channel, wherein the N-well and the P-well form a drift region (106), and wherein the drift region (106) is positioned on the top of the substrate (102);
c. etching a trench (105);
d. growing a sacrificial (SAC) oxide and a gate terminal oxide (GOX) within the trench (105);
e. deposing a first polysilicon layer (108) in the trench (105);
f. removing a top part of the first polysilicon layer (108);
g. deposit or grow a RESURF oxide on the top of the first polysilicon layer (108);
h. deposit a second polysilicon layer on the top of the RESURF oxide;
i. removing a top part of the second polysilicon layer (110);
j. deposit or grow a RESURF oxide on the top of the second polysilicon layer (110);
k. deposit a third polysilicon layer (111) on the top of the RESURF oxide, and
l. inserting a high concentration implant so to form a source, a drain and a contact open so to pick up the source and the drain.
